Europäisches Patentamt

European Patent Office

Office européen des brevets

(11) Veröffentlichungsnummer: **0 617 331 A1**

# (12) EUROPÄISCHE PATENTANMELDUNG

(21) Anmeldenummer: **94103958.8**

(22) Anmeldetag: **15.03.94**

(51) Int. Cl.⁵: **G03F 7/11**

(30) Priorität: **15.03.93 DE 4308122**

(43) Veröffentlichungstag der Anmeldung:
**28.09.94 Patentblatt 94/39**

(84) Benannte Vertragsstaaten:
**BE DE FR GB IT NL**

(71) Anmelder: **BASF Lacke + Farben AG**
**Glasuritstrasse 1**
**D-48165 Münster-Hiltrup (DE)**

(72) Erfinder: **Bronstert, Bernd, Dr.**
**Zanderstrasse 35**
**D-67166 Otterstadt (DE)**
Erfinder: **Loerzer, Thomas, Dr.**
**Erlenbergstrasse 37**
**D-67435 Neustadt (DE)**
Erfinder: **Huemmer, Wolfgang, Dr.**
**Danziger Strasse 9**
**D-67134 Birkenheide (DE)**
Erfinder: **Kingma, Arend Jouke, Dr.**
**Ruedigerstrasse 48**
**D-67069 Ludwigshafen (DE)**
Erfinder: **Telser, Thomas, Dr.**
**Langer Wiesenweg 13**
**D-69469 Weinheim (DE)**
Erfinder: **Zwez, Thomas, Dr.**
**Allmendstrasse 8**
**D-76199 Karlsruhe (DE)**

(74) Vertreter: **Langfinger, Klaus-Dieter, Dr.**
**BASF Aktiengesellschaft,**
**Patentabteilung ZDX - C 6**
**D-67056 Ludwigshafen (DE)**

(54) **Photostrukturierbares mehrschichtiges Element, Verfahren zu dessen Herstellung sowie daraus hergestellte Druck-und Prägeform.**

㊼ Die Erfindung betrifft ein photostrukturierbares mehrschichtiges Element zur Herstellung von Reliefformen, bestehend aus mindestens einer festen photostrukturierbaren Schicht und einer darauf angebrachten Entklebungs- oder Deckschicht, wobei die phototrukturierbare Schicht gegebenenfalls mittels einer Haftschicht auf einem dimensionsstabilen Träger aufgebracht ist und die Entklebungs- oder Deckschicht aus einer transparenten mikrodispersen mehrphasigen Schicht eines oder mehrerer feinteiliger hydrophober wasserunlöslicher Polymerer mit einem Primärpartikeldurchmesser von 0,01 bis 10 µm, die von mindestens einem ionischen oder nichtionischen Tensid oder einem polymeren Bindemittel, das wasserlöslich oder wasserquellbar ist, oder von einem Gemisch aus derartigem Tensid und derartigem polymeren Bindemittel umhüllt sind, besteht.

Die erfindungsgemäßen photostrukturierbaren mehrschichtigen Elemente eignen sich zur Herstellung von Druck- und Prägeformen.

Die Erfindung betrifft ein photostrukturierbares mehrschichtiges Element zur Herstellung von Reliefformen, bestehend aus mindestens einer festen photostrukturierbaren Schicht und einer darauf angebrachten Entklebungs- oder Deckschicht, wobei die photostrukturierbare Schicht, gegebenenfalls mittels einer Haftschicht, auf einem dimensionsstabilen Träger aufgebracht ist und die auf der photostrukturierbaren Schicht angebrachte Entklebungs- oder Deckschicht aus einer transparenten mikrodispersen mehrphasigen Schicht besteht. Die Erfindung betrifft außerdem ein Verfahren zur Herstellung derartiger photostrukturierbarer mehrschichtiger Elemente sowie daraus hergestellte Druck- und Prägeformen.

Für die Herstellung von Reliefdruckformen geeignete Mehrschichtelemente mit photosensitiven Schichten, die beispielsweise lösliche Polyamide, Polyvinylalkohole oder Kautschuke als polymere Bindemittel in Kombination mit copolymerisierbaren ethylenisch ungesättigten organischen Verbindungen als Vernetzer, Photoinitiator und Hilfsstoffe enthalten, sind bekannt (vgl. z.B. DE-A-19 02 639, DE-A-2427494, DE-A-3704067, EP-A-0225676, EP-A-0251228, EP-A-0260834, EP-A-0072918, EP-A-0081964, EP-A-0092794, US-A-4599299, US-A-4469775, US-A-3877939, DE-A-3226779, US-A-3801321, JP-A-63010150, WO 7900-434).

Diese Druckplatten können auch mit abziehbaren Polyesterschutzfolien abgedeckt sein. Außerdem sind bereits Druckschichten aus z.B. Polyvinylalkohol oder Polyamid zwischen einer vor Gebrauch abzuziehenden Schutzfolie und der reliefbildenden Schicht (vgl. z.B. EP-A-0504824) bekannt.

In der US-A 4 599 299 ist ein Verfahren zur Herstellung lichthärtbarer Elemente mit einer Deckschicht, die Oberflächenrauhigkeiten aufweist, und ein oder zwei darunter angebrachten lichthärtbaren Schichten beschrieben, wobei die unmittelbar unterhalb der nichtempfindlichen Deckschicht angebrachte lichthärtbare Schicht diskrete inerte Partikel oder Kugeln aus Polymeren, wie vernetzten nicht quellbaren (Meth)acrylatcopolymerisaten oder Polyethylen enthält, die in der darüber liegenden Deckschicht Unebenheiten (protuberances) erzeugen, und die Deckschicht beispielsweise aus Polyvinylalkohol oder Gelatine bestehen kann. Bei Verwendung dieser lichthärtbaren Elemente zur Herstellung von Druckformen bleiben die diskreten inerten Polymerpartikel, die Teilchendurchmesser zwischen 0,1 und 10 $\mu$m aufweisen, auch nach bildmäßiger Belichtung und Entwicklung in den lichtgehärteten Bereichen erhalten. Die Oberflächen der Druckformen sind so besonders klebfrei.

Der JP-A 02135348 ist eine Reliefdruckplatte zu entnehmen, wobei ein PTFE-Überzug auf einer Glasplatte aufgebracht wird. PMMA wird dann mittels spin-coating aufgebracht, mit UV-Licht wird das gewünschte Druckmuster erzeugt, mit Methylisobutylketon und Isopropanol zur Erzeugung der Maske entwickelt und schließlich die Glasplatte mit NH$_4$F-Lösung geätzt.

In der JP-A 04147146 wird ein wasserfester lichtempfindlicher Film für den Siebdruck beschrieben, wobei auf einer ersten Schicht, die als drukkende Schicht dient und aus Polyvinylalkohol, einem photopolymerisierbaren Monomer, einem Photopolymerisationsinitiator, einem Vernetzer und einem feinteiligen Polyethylen oder PTFE zusammengesetzt ist, eine zweite Schicht aufgebracht wird, die aus Polyvinylalkohol, Monomer, Photoinitiator, Vernetzer und einer hydrophoben hochmolekularen Emulsion besteht. Dieser lichtempfindliche Film kann mit Wasser entwickelt werden.

Auch aus EP-A-306 932 sind Druckplatten bekannt, deren druckende Bereiche aus Fluorpolymer oder Polyolefin bestehen, deren kritische Oberflächenspannung durch Perfluoralkylgruppen eingestellt wird.

In der DE-A-2533156 wird ein Verfahren zur Herstellung von lichtempfindlichen Druckplatten beschrieben, wobei die obere Schicht der lichtempfindlichen Druckplatte unter Verwendung einer Walze mit unebener bzw. ungleichmäßiger Oberfläche aufgebracht wird. Die Walze kann eine Oberfläche aus PTFE, Polyethylen, PVC, Kohlenstoffasern oder nicht-rostendem Stahl haben.

Der EP-A-356 954 sind Trennschichten aus mit Polyethylenglykol weichgemachtem Polyvinylalkohol für Flexodruckplatten zu entnehmen.

In der EP-A-0251228 wird eine lichtempfindliche Flexodruckplatte beschrieben, die auf einem Träger eine lichtempfindliche Harzschicht trägt, die aus gummielastischem Harz, ungesättigtem Monomer, Photopolymerisationsinitiator und Harzteilchen mit einer Teilchengröße von etwa 0,01 bis 6 $\mu$m zusammengesetzt ist, wobei die Harzteilchen durch Copolymerisation von ethylenisch ungesättigten Monomeren mit vernetzbaren copolymerisierbaren Monomeren in Emulsion oder Suspension erhalten werden.

Der EP-A-0081964 sind lichtempfindliche Polymerzusammensetzungen zu entnehmen, die aus teilweise verseiftem Polyvinylacetat, mehrfunktionellem (Meth)acrylat und hydroxylgruppenhaltigem Weichmacher bestehen und zur Herstellung wasserentwickelbarer Hochdruckplatten dienen sollen.

Photopolymerdruckplatten, die im Bindemittel dispergierte Teilchen, wie Glasperlen, PTFE-Pulver oder Tonerde enthalten, sind auch in der WO 7900-434 beschrieben.

In der EP-A-0225676 werden lichtempfindliche Druckplatten beschrieben, die auf einem Träger eine lichtempfindliche Harzschicht und darauf eine Deckschicht tragen, wobei diese Deckschicht einen hochmolekularen im Entwickler löslichen oder quellbaren Stoff (Cellulosederivat oder teilweise verseiftes Polyvinylacetat) und 0,2 bis 20 Gew.-% eines Farbstoffs enthält.

In der DE-A-3704067 wird ein Verfahren zum Nicht-klebrigmachen der Oberfläche einer Harzplatte durch nachträgliches Aufbringen einer Lösung eines Bindemittels und eines photopolymerisierbaren Monomeren auf die Oberfläche eines aus einem lichtempfindlichen Harz erhaltenen, bildmäßig belichteten und entwickelten Reliefbildes beschrieben.

In der DE-A-3226779 wird ein Verfahren zur Herstellung, Trocknung und Lagerfähigkeit von zur Herstellung von Reliefdruckformen geeigneten Mehrschichtelementen beschrieben, wobei als Deckschicht eine Schicht aus hochverseiftem Polyvinylalkohol dient.

Druckplatten dieser Art lassen jedoch noch viele Wünsche bezüglich ihrer Herstellung, des einsetzbaren Filmmaterials und ihrer Kopiereigenschaften, offen.

Bei Druckplatten mit reliefbildender Schicht auf Polyvinylalkoholbasis, die mit keiner Deckschicht versehen sind und eine Schutzfolie (meistens aus Polyethylenterephthalat) tragen, ist im allgemeinen das Verkleben mit dem Negativ bei technisch vertretbar niedrigem Restlösemittelgehalt, insbesondere beim Einsatz von glatten Negativen, wie sie für die Kopie von Offsetdruckplatten üblicherweise verwendet werden, problematisch, da sich so Kopierfehler und Unterstrahlungen ergeben. Von den vielen Unterstrahlungsstellen abgesehen kopieren Rasterfelder, Linienelemente und Punkte schmaler als vom Filmnegativ vorgegeben.

Bei Druckplatten mit reliefbildender Schicht auf Polyvinylalkoholbasis, die mit Deckschichten aus Polyvinylacetat eines Verseifungsgrades < 88 %, Polyamid, Polyacrylat oder anderen löslichen Polymeren versehen sind und eine Schutzfolie tragen, wird ebenfalls ein Verkleben beim Einsatz glatter Negative bei technisch vertretbar niedrigem Restlösemittelgehalt beobachtet, was zu Kopierfehlern und Unterstrahlungen führt, während matte Negative eingesetzt werden können, ohne daß Unterstrahlungen erfolgen, und Rasterfelder, Linienelemente und Punkte etwa wie vom Filmnegativ vorgegeben kopieren.

Bei Druckplatten mit reliefbildender Schicht auf Polyvinylalkoholbasis, die mit Deckschichten aus Polyvinylacetat eines Verseifungsgrades > 88 % versehen sind und eine Schutzfolie tragen, tritt zwar in der Regel aufgrund der hohen Unverträglichkeit dieser Polyvinylalkoholtypen mit den Monomeren und Weichmachern kein Verkleben mit glatten Negativen und demzufolge auch keine Unterstrahlungen mehr auf; problematisch ist dann jedoch die deutliche Kopierverbreiterung von Rasterfeldern, Linienelementen und Punkten, die dann breiter ausfallen als vom Filmnegativ vorgegeben.

Da für die Qualität einer Druckplatte ein spitzes Kopierergebnis von besonderer Wichtigkeit ist, ergibt sich aus dem geschilderten Sachverhalt eine mit bisherigen Mitteln unlösbare Scherenbeziehung: Guter Negativkontakt nur unter Verzicht auf eine spitze Reproduktion der Reliefelemente bzw. eine spitze Reproduktion der Reliefelemente geht auf Kosten des guten Negativkontaktes, der Belichtbarkeit mit glatten Offsetfilmen und/oder erfordert einen extrem niedrigen Restlösemittelgehalt, wie er nur bei sehr langsamer Fahrgeschwindigkeit (teure Herstellung!) erreicht werden kann. Unter spitzem Kopierergebnis bzw. spitzer Reproduktion versteht man, daß feine Elemente der Druckform ( = des Klischees) wie z.B feine Linien oder Punkte schmaler, bzw. feiner durch die Photopolymerisation reproduziert werden, als es durch die Breite der Linien bzw. des Durchmessers der Punkte im Filmnegativ vorgegeben ist. Durch dieses spitzere Kopieren wird die technisch bedingte unvermeidbare Verbreiterung der feinen Reliefelemente im Druckerzeugnis durch das Druckverfahren (Buchdruck) kompensiert. Die technisch bedingte Verbreiterung der Linien bzw. Punkte im Druck kommt durch die sogenannte Quetschrandbildung, bei der die Druckfarbe über den Rand der Reliefelemente hinaus gedruckt wird und den Bedruckstoff einfärbt, zustande.

Als Problem bei Druckplatten mit reliefbildender Schicht auf Basis von Polyamid, abgedeckt mit PETP-Schutzfolie, aber ohne Deckschicht beobachtet man starkes Verkleben mit dem Negativ bei technisch vertretbar niedrigem Restlösemittelgehalt, insbesondere beim Einsatz von glatten Negativen, wie sie für die Kopie von Offsetdruckplatten üblicherweise verwendet werden. Es resultieren Kopierfehler und Unterstrahlungen. Von den vielen Unterstrahlungsstellen abgesehen kopieren aber Rasterfelder, Linienelemente und Punkte wie erwünscht schmaler als vom Filmnegativ vorgegeben.

Als Problem bei Druckplatten mit reliefbildender Schicht auf Basis von Polyamid, abgedeckt mit PETP-Schutzfolie und mit einer Deckschicht aus löslichem Polyamid zeigt sich ein Verkleben bei Einsatz glatter Negative bei technisch vertretbar niedrigem Restlösemittelgehalt. Es resultieren Kopierfehler und Unterstrahlungen. Matte Negative können ohne Unterstrahlungen eingesetzt werden. Rasterfelder, Linienelemente und Punkte kopieren wie erwünscht schmaler als vom Filmnegativ vorgegeben.

Bei Druckplatten mit reliefbildender Schicht auf Basis von Polyamid, abgedeckt mit PETP-Schutzfolie und versehen mit einer Deckschicht aus zu > 88 % verseiftem Polyvinylacetat tritt in der Regel aufgrund der hohen Unverträglichkeit dieser Polyvinylalkohol-Typen mit den Monomeren und Weichmachern kein Verkleben mit glatten Negativen mehr auf und demzufolge auch keine Unterstrahlungen. Mit den üblichen Auswaschlösemitteln für Polyamidplatten Ethanol/Wasser 80/20 lassen sich jedoch die Deckschichten nicht richtig auswaschen. Rasterfelder und kleine Näpfchen im Relief werden von Polyvinylalkohol-Häutchen überspannt. Ein zusätzlicher Vorwaschschritt mit Wasser schafft hier Abhilfe. Abgesehen von dieser erschwerten Verarbeitung bereitet jedoch die unerwünschte Kopierverbreiterung von Rasterfeldern, Linienelementen und Punkten, die breiter als vom Filmnegativ vorgegeben kopieren, Probleme.

Bei Druckplatten mit reliefbildender Schicht auf Basis Styrol/ Isopren/Styrol- oder Styrol/Butadien/Styrol-Blockcopolymerkautschuk mit einer Polyamid-Deckschicht sind Alkohole im Auswaschlösungsmittel notwendig, die wegen ihres niedrigen Flammpunkts problematisch sind und aufwendige Überwachungsmaßnahmen sowie Nachdosieren nötig machen. Wenn bei derartigen Druckplatten die Polyamid-Deckschicht durch eine Polyvinylalkohol-Deckschicht ersetzt wird, ergibt sich beim Kopieren eine Linienverbreiterung.

Aufgabe der vorliegenden Erfindung ist es, bei den oben aufgezeigten Problemen Abhilfe zu schaffen. Dies gelingt überraschenderweise durch den Einsatz von Entklebungs- oder Deckschichten aus einer transparenten mikrodispersen mehrphasigen Schicht eines feinteiligen hydrophoben wasserunlöslichen Polymeren mit einem Primärpartikeldurchmesser von 0,01 bis 10 $\mu$m, das von einem ionischen oder nicht ionischen Tensid und/oder einem polymeren wasserlöslichen oder wasserquellbaren Bindemittel umhüllt ist.

Gegenstand der vorliegenden Erfindung ist daher ein photostrukturierbares mehrschichtiges Element zur Herstellung von Reliefformen, bestehend aus mindestens einer festen photostrukturierbaren Schicht und einer darauf angebrachten Entklebungs- oder Deckschicht, wobei die photostrukturierbare Schicht, gegebenenfalls mittels einer Haftschicht, auf einem dimensionsstabilen Träger aufgebracht ist, das dadurch gekennzeichnet ist, daß die auf der photostrukturierbaren Schicht angebrachte Entklebungs- oder Deckschicht aus einer transparenten mikrodispersen mehrphasigen Schicht eines oder mehrerer feinteiliger hydrophober wasserunlöslicher Polymerer mit einem Primärpartikeldurchmesser von 0,01 bis 10 $\mu$m, die von mindestens einem ionischen oder nichtionischen Tensid oder einem polymeren Bindemittel, das wasserlöslich oder wasserquellbar ist, oder von einem Gemisch aus derartigem Tensid und derartigem polymeren Bindemittel umhüllt sind, besteht, wobei der Anteil der feinteiligen hydrophoben wasserunlöslichen Polymeren in der Entklebungs- oder Deckschicht 30 bis 99,9 Gew.-% der Gesamtmenge der Entklebungs- oder Deckschicht beträgt.

Bevorzugt als derartige Entklebungs- oder Deckschichten sind solche, die als feinteiliges hydrophobes wasserunlösliches Polymer ein Polyolefin oder Polytetrafluorethylen enthalten.

In den erfindungsgemäßen photostrukturierbaren mehrschichtigen Elementen sind ferner solche Entklebungs- oder Deckschichten bevorzugt, die als wasserlösliche oder wasserquellbare polymere Bindemittel in der transparenten mikrodispersen mehrphasigen Schicht Polyvinylalkohol, ein Polyvinylalkoholderivat oder ein Polyamid sowie gegebenenfalls zusätzlich in Wasser nicht lösliche Bindemittel enthalten.

Gegenstand der vorliegenden Erfindung ist auch ein Verfahren zur Herstellung der erfindungsgemäßen photostrukturierbaren mehrschichtigen Elemente, wobei die Entklebungs- oder Deckschicht durch Auftragen einer wasserhaltigen Dispersion eines feinteiligen hydrophoben wasserunlöslichen Polymeren, die ein ionisches oder nichtionisches Tensid und/oder ein wasserlösliches oder wasserquellbares polymeres Bindemittel enthält, auf die photostrukturierbare Schicht hergestellt wird.

Das erfindungsgemäße Verfahren läßt sich besonders vorteilhaft durchführen, wenn zunächst auf einer dimensionsstabilen Schutzfolie, die z.B. aus Polyester besteht und mit einer dünnen Haftvermittlerschicht versehen sein kann, ein Gemisch aus Wasser bzw. Wasser/Alkohol, feinteiliger wäßriger Polyethylen- oder Polytetrafluorethylendispersion und einem ionischen oder nichtionischen Tensid und/oder einer wäßrigen Lösung eines Polyvinylalkohols, Polyvinylalkoholderivats oder Polyamids auf die dimensionsstabile Schutzfolie in einer solchen Menge aufgetragen wird, daß nach dem Trocknen eine Trockenschichtdicke von 0,1 bis 20, vorzugsweise 0,5 bis 10 g/m$^2$ resultiert, auf diese Schicht dann eine Lösung der photostrukturierbaren Schicht in gewünschter gleichmäßiger Schichtdicke aufgetragen, getrocknet und auf einen mit Haft- und Oberlack versehenen Träger mit Hilfe einer wäßrig/alkoholischen Lösung unter Druck aufgeklebt wird, so daß sich eine Druckplatte des Aufbaus Träger/Haftlack/Oberlack/photostrukturierbare Schicht/Deck- oder Entklebungsschicht/Schutzfolie ergibt.

Gegenstand der vorliegenden Erfindung ist schließlich auch eine Reliefform zum Drucken oder Prägen, die durch bildmäßiges Belichten und Entwickeln des nach dem erfindungsgemäßen Verfahren hergestellten photostrukturierbaren mehrschichtigen Elements erhalten worden ist.

Die erfindungsgemäßen photostrukturierbaren mehrschichtigen Elemente zeichnen sich durch hervorragende Entklebung der Rohrplattenoberfläche aus, so daß nach Entfernen der Schutzfolie zur bildmäßigen Belichtung keine Probleme beim Auflegen der Negative bestehen. Auch die bei ihrer Verarbeitung zu beobachtenden Vorteile sind überraschend, wie das spitze Kopierergebnis (d.h. Rasterlinien und -punkte werden etwas schmaler als den transparenten Linien und Punkten im Negativ entspricht) und die vollständige Entfernung der Entklebungsschicht beim Auswaschen (Entwickeln), ohne daß die Auswaschzeit verlängert wird.

Zu den Aufbaukomponenten des erfindungsgemäßen photostrukturierbaren mehrschichtigen Elements, zu den Verfahren zu seiner Herstellung den damit herstellbaren Reliefformen ist im einzelnen folgendes auszuführen.

Die photostrukturierbare Schicht, d.h. die reliefbildende Schicht, besteht im allgemeinen aus einem oder mehreren polymeren Bindemitteln, mit diesem Bindemittel verträglichen copolymerisierbaren ethylenisch ungesättigten organischen Verbindungen, einem Photoinitiator oder Photoinitiatorsystem sowie gegebenenfalls weiteren Hilfs- und Zusatzstoffen, wie Inhibitoren der thermischen Polymerisation, Weichmacher und/oder Farbstoffe.

Als polymere Bindemittel kommen die für den Aufbau von Druckplatten üblichen in Betracht, wie vollständig oder teilweise verseifte Polyvinylester, z.B. teilverseifte Polyvinylacetate, Polyvinylalkoholderivate, wie z.B. teilverseiftes Vinylacetat/Alkylenoxid-Pfropfmischpolymerisat, oder nachträglich polymeranalog acylierte Polyvinylalkohole, wie sie beispielsweise in EP-A-0079514, EP-A-0224164, EP-A-0226079 oder EP-A-0059988 beschrieben sind, sowie deren Gemische.

Ebenso eignen sich als polymere Bindemittel (a) in Wasser, Wasser/Alkohol oder in Alkohol lösliche Polyamide, wie sie beispielsweise in EP-A-0085472 oder DE-A-1522444 beschrieben sind, sowie Kautschuke, wie z.B. solche auf Basis von löslichen oder thermoplastisch verarbeitbaren Kautschuken, vorzugsweise Blockcopolymerisate auf Basis Styrol/Butdadien/Styrol, Styrol/Isopren/ Styrol, Ethylen(Meth)acrylsäure-Copolymere, Ethylen/Propylen/(Meth)acrylsäure-Terpolymere und andere.

Diese polymeren Bindemittel machen in der photostrukturierbaren Schicht im allgemeinen 50 bis 98, vorzugsweise 60 bis 95 Gew.-% der Gesamtmenge der photostrukturierbaren Schicht aus.

Als copolymerisierbare ethylenisch ungesättigte organische Verbindungen kommen solche in Betracht, die mit den jeweils ausgewählten polymeren Bindemitteln verträglich sind. Im allgemeinen sind dies bei Raumtemperatur nicht gasförmige ein- und/oder mehrfach olefinisch ungesättigte organische Verbindungen, insbesondere Derivate der Acryl- und/oder Methacrylsäure, wie deren Ester mit ein- oder mehrwertigen Alkoholen, beispielsweise Acryl- oder Methacrylsäureester von Alkanolen mit 1 bis 20 Kohlenstoffatomen, z.B. Methylmethacrylat, Ethylacrylat, Propyl(meth)acrylat, Isopropyl-(meth)acrylat, n-Butyl(meth)acrylat, Isobutyl(meth)-acrylat, tert.-Butyl(meth)acrylat, Hexyl(meth)acrylat, Cyclohexyl(meth)acrylat, 2-Ethyl-hexyl(meth)-acrylat, Lauryl(meth)acrylat, (Meth)acrylester mehrwertiger Alkohole mit 2 bis 20 Kohlenstoffatomen, z.B. 2-Hydroxyethyl(meth)acrylat, 2-Hydroxypropyl-(meth)acrylat, Ethylenglykoldi(meth)acrylat, Polyethylenglykoldi(meth)acrylat, Butandiol-1,4-di-(meth)acrylat, Neopentylglykol-di(meth)acrylat, 3-Methylpentandiol-di(meth)acrylat, 1,1,1-Trimethylolpropantri(meth)-acrylat, Di-, Tri- und Tetraethylenglykoldi(meth)acrylat, Tripropylenglykol-di(meth)acrylat oder Pentaerythrittetra(meth)-acrylat, des weiteren Poly(ethylenoxid)di(meth)-acrylat, ω-Methylpoly(ethylenoxid)-α-yl-(meth)-acrylat, N,N-Diethylaminoethylacrylat, ein Umsetzungsprodukt aus 1 mol Glycerin, 1 mol Epichlorhydrin und 3 Mol Acrylsäure sowie Glycidylmethacrylat und Bisphenol-A-diglycidetheracrylat.

Ebenso eignen sich Derivate des Acrylamids und Methacrylamids, wie z.B. die Ether ihrer N-Methylolderivate mit ein- und mehrwertigen Alkoholen, z.B. Ethylenglykol, Glycerin, 1,1,1-Trimethylolpropan, oligomeren oder polymeren Ethylenoxidderivaten. Diese eignen sich besonders, wenn Polyamide oder Polyvinylalkohol als polymere Bindemittel eingesetzt werden.

Geeignet sind auch sogenannte Epoxid- und Urethan(meth)acrylate, wie sie beispielsweise durch Umsetzung von Bisphenol-A-diglycidylether mit (Meth)acrylsäure oder durch Umsetzung von Diisocyanaten mit Hydroxyalkyl(meth)acrylaten oder mit hydroxylgruppenhaltigen Polyestern oder Polyethern erhalten werden können. Weiterhin einsetzbare olefinisch ungesättigte organische Verbindungen sind Ester der Acryl- oder Methacrylsäure, insbesondere solche mit niedrigem Dampfdruck und solche, die mit Verträglichkeitsvermittlern modifiziert sind, z.B. mit Hydroxy-, Amido-, Sulfoester- oder Sulfonamidgruppen. Auch Gemische der obengenannten copolymerisierbaren ethylenisch ungesättigten organischen Verbindungen können eingesetzt werden. Die copolymerisierbaren ethylenisch ungesättigten organischen Verbindungen können in der photostrukturierbaren Schicht in Mengen von 1 bis 60, vorzugsweise 10 bis 45 Gew.-%, bezogen auf die Gesamtmenge der photostrukturierbaren Schicht enthalten sein.

Als Photoinitiatoren oder Photoinitiatorsysteme kommen die für lichtempfindliche Aufzeichnungsmaterialien allgemein üblichen in Frage, beispielsweise radikalliefernde Photoinitiatoren, wie z.B. Benzoin oder Benzoinderivate, wie Benzoinether geradkettiger oder verzweigter Monoalkohole mit 1 bis 6 Kohlenstoffatomen, z.B. Benzoinmethyl-, -ethyl-, -isopropyl-, -n-butyl-, -isobutylether, symmetrisch oder unsymmetrisch substituierte Benzilacetale, wie Benzildimethylacetal, Benzil-1-methyl-1-ethylacetal, Diarylphosphinoxide, wie z.B. 2,4,6-Trimethylbenzoyldiphenylphosphinoxid oder 2,6-Dimethoxybenzoyldiphenylphosphinoxid oder Acyldiarylphosphinoxide gemäß DE-OS 29 09 992, Diacylphosphinoxide oder substituierte und unsubstituierte Chinone, wie Ethylanthrachinon, Benzanthrachinon, Benzophenon oder 4,4'-Bis(dimethylamino)-benzophenon. Sie können allein oder im Gemisch miteinander oder in Verbindung mit Coinitiatoren verwendet werden, z.B. Ethylanthrachinon mit 4,4'-Bis- (dimethylamino)benzophenon, Benzoinmethylether mit Triphenylphosphin, Diacylphosphinoxide mit tertiären Aminen oder Acyldiarylphosphinoxide mit Benzildimethylacetal.

Die Photoinitiatoren sind in der photostrukturierbaren Schicht üblicherweise in Mengen von 0,1 bis 10, vorzugsweise 0,5 bis 5 Gew.-%, bezogen auf die Gesamtmenge der photostrukturierbaren Schicht enthalten.

Außer polymerem Bindemittel, damit verträglichen copolymerisierbaren olefinisch ungesättigten organischen Verbindungen und Photoinitiator können in der photostrukturierbaren Schicht weitere Hilfs- und Zusatzstoffe enthalten sein, beispielsweise können in Mengen von 0,001 bis 2 Gew.-% bezogen auf die Gesamtmenge der photostrukturierbaren Schicht Inhibitoren gegen die thermische Polymerisation, die keine nennenswerte Eigenabsorption in dem aktinizchen Bereich, in dem der Photoinitiator absorbiert, aufweisen, zugesetzt werden, wie z.B. 2,6-Di-tert.-butyl-p-kresol, Hydrochinon, p-Methoxiphenol, $\beta$-Naphthol, Phenothiazin, Pyridin, Nitrobenzol, m-Dinitrobenzol oder Chloranil; Thiazinfarbstoffe, wie Thioninblau G (C.I. 52025) Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze des N-Nitrosocyclohexylhydroxylamins.

Auch geeignete Farbstoffe, Pigmente oder photochrome Zusätze können der erfindungsgemäßen photostrukturierbaren Schicht in einer Menge von 0,0001 bis 2 Gew.-%, bezogen auf das Gemisch, zugesetzt sein. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie ebenso wenig wie die Inhibitoren der thermisch initiierten Polymerisation die Photopolymerisation der Gemische stören. Geeignet sind z.B. die löslichen Phenazinium-, Phenoxazinium-, Acridinium- und Phenothiaziniumfarbstoffe, wie Neutralrot (C.I. 50040), Safranin T (C.I. 50240), Rhodanilblau, dem Salz bzw. Amid aus Rhodamin D (Basic Violett 10), Rhodanilblau, dem Salz bzw. Amid aus Rhodamin D (Basic Violett 10, C.I. 45170), Methylenblau B (C.I. 52015), Thioninblau G (C.I. 52025), oder Acridinorange (C.I. 46005); sowie auch Solvent Black 3 (C.I. 26150). Diese Farbstoffe können auch zusammen mit einer hinreichenden Menge eines Reduktionsmittels verwendet werden, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexyl-hydroxlamins, vorzugsweise die Kalium-, Calcium- und Aluminiumsalze. Letztere können, wie erwähnt, zugleich als Inhibitoren der thermisch initiierten Polymerisation dienen. Die Reduktionsmittel können im allgemeinen in Mengen von 0,005 bis 5 Gew.-%, bezogen auf das Gemisch, zugesetzt werden, wobei sich in vielen Fällen der Zusatz eines 3- bis 10fachen der Menge an mitverwendetem Farbstoff bewährt hat.

Die Herstellung der photostrukturierbaren Schicht aus den einzelnen Bestandteilen kann in üblicher Weise durch Mischen der Bestandteile mit Hilfe bekannter Mischmethoden und durch Verarbeitung dieser Mischung zur photostrukturierbaren Schicht mit Hilfe bekannter Techniken, wie Gießen aus Lösung, Kalandrieren oder Extrudieren, erfolgen, wobei diese Maßnahmen auch in geeigneter Weise miteinander kombiniert werden können. Die Stärke der photostrukturierbaren Schicht beträgt zweckmäßigerweise ca. 1 $\mu$m bis 5 mm, insbesondere 100 $\mu$m bis 2 mm.

Die photostrukturierbare Schicht befindet sich, gegebenenfalls mittels einer Haftschicht und einer Oberlackschicht, auf einem dimensionsstabilen Träger.

Beispiele geeigneter dimensionsstabiler Träger sind Platten, Folien sowie konische und zylindrische Röhren (sleeves) aus Metallen wie Stahl, Aluminium, Kupfer oder Nickel oder aus Kunststoffen, wie Polyethylenterephthalat (= PETP), Polybutylenterephthalat, Polyamid und Polycarbonat, gegebenenfalls auch Gewebe und Vliese, wie Glasfasergewebe sowie Verbundmaterialien aus Glasfasern und Kunststoffen.

Als Haftlackschichten können beispielsweise Polyurethanhaftlacke (z.B. gemäß DE-A-30 45 516) auf Basis von polyisocyanatvernetzten Polyether- oder Polyesterlacken in Schichtdicken zwischen 0,5 und 50, inbesondere zwischen 2 und 30 $\mu$m dienen.

Oberlackschichten können sich auf der von der Trägerschicht abgewandten Seite der Haftlackschicht befinden, weisen Schichtdicken zwischen 0,1 und 50, insbesondere 1 und 10 $\mu$m, auf und

können beispielsweise aus verdünnter wäßrig/alkoholischer Lösung von (zu z.B. 80 Mol%) teilverseiften Polyvinylester, Phenylglycerinethermonocrylat und Glyoxal, durch Trocknen und Einbrennen erhalten werden.

Auf der photostrukturierbaren Schicht befindet sich erfindungsgemäß eine Entklebungs- oder Deckschicht, die aus einer transparenten mikrodispersen mehrphasigen Schicht eines feinteiligen hydrophoben wasserunlöslichen Polymeren mit einem Primärpartikeldurchmesser von 0,01 bis 10 $\mu$m, vorzugsweise von 0,1 bis 2 $\mu$m, das von mindestens einem ionischen oder nichtionischen Tensid oder einem polymeren Bindemittel, das wasserlöslich oder wasserquellbar ist, oder von einem Gemisch aus derartigem Tensid und derartigem polymeren Bindemittel umhüllt ist, besteht, wobei der Anteil des feinteiligen hydrophoben wasserunlöslichen Polymeren in der Entklebungs- oder Deckschicht 30 bis 99,9, vorzugsweise 50 bis 95 Gew.-% der Gesamtmenge der Entklebungs- oder Deckschicht beträgt.

Unter hydrophoben wasserunlöslichen Polymeren im Sinne der vorliegenden Erfindung werden solche Polymeren verstanden, auf deren Oberfläche Wasser nicht spreitet und/oder einen Randwinkel von > 40° ausbildet.

Beispiele für derartige hydrophobe wasserunlösliche Polymere sind Polyvinylaromaten, wie z.B. Polystyrol, Styrolcopolymere, insbesondere Polyolefine, wie Polyethylen, Polypropylen, deren Copolymere, Polyvinylchlorid sowie vorzugsweise fluorhaltige Polymere, wie Polytetrafluorethylen (= PTFE). Diese liegen in feinteiliger Form mit Primärpartikeldurchmessern von 0,01 bis 10 $\mu$m, vorzugsweise 0,1 bis 2 $\mu$m vor, wobei die hydrophoben Polymerpartikel von ionischem oder nichtionischem Tensid und/oder wasserlöslichem oder wasserquellbarem Bindemittel umhüllt sind. Als ionische bzw. nichtionische Tenside kommen beispielsweise in Frage Polyethylenoxide, Polypropylenoxide, Polyethylenoxid/Polypropylenoxid-Pfropfmischpolymerisate, sowie deren Derivate. Als wasserlösliche oder zumindest wasserquellbare polymere Bindemittel kommen hydrophile Polymerisate und Copolymerisate in Frage, wie z.B. teilweise oder vollständig verseifte Polyvinylester, Polyvinylalkohole, Polyvinylalkoholderivate, teilverseiftes Polyethylenoxid/Polyvinylester-Copolymer, Polyvinylpyrrolidon, lösliche Polyamide, natürliche und modifizierte natürliche Polymere, z.B. Cellulosederivate, Polysaccharide, Gelatine usw.

Zur Herstellung der Entklebungs- oder Deckschicht der erfindungsgemäßen photostrukturierbaren mehrschichtigen Elemente eignen sich vorzugsweise wäßrige oder mit wasserlöslichen organischen Lösungsmitteln, wie Alkoholen, z.B. Methanol, Ethanol, verdünnte Dispersionen feinteiliger hydrophober wasserunlöslicher Polymerer, die beispielsweise nach den üblichen Methoden der Emulsionspolymerisation aus den entsprechenden Monomeren in Gegenwart radikalliefernder Polymerisationsinitiatoren, wie z.B. N,N-Azodiisobutyronitril oder Benzoylperoxid, und geeigneter Dispergiermittel, wie ionischer und/oder nichtionischer Tenside der obengenannten Art, erhältlich sind oder durch übliche Zerkleinerungsverfahren, wie z.B. Mahlen in Kugelmühlen, gewonnen werden können, beispielsweise Latexemulsionen (z.B. Dow-Latex 277), mit denen die Transparenz der Entklebungsschicht verbessert, bzw. die Lichtstreuung herabgesetzt werden kann.

In diesen wäßrigen Polymerdispersionen können noch weitere Hilfs- und Zusatzstoffe in untergeordneten Mengen von bis zu 30 Gew.-%, bezogen auf die Gesamtmenge wäßriger Polymerdispersion, enthalten sein, beispielsweise Entschäumer, wie z.B. Silikonentschäumer. Es können auch in Wasser nicht lösliche Bindemittel enthalten sein. Die wäßrigen Polymerdispersionen können Feststoffgehalte zwischen 0,1 und 70 Gew.-% aufweisen. Das Verhältnis Tensid und/oder wasserlösliches oder wasserquellbares polymeres Bindemittel zu feinverteilten wasserunlöslichen hydrophoben Polymeren in der wäßrigen Dispersion ist so einzustellen, daß nach Entfernung von Wasser und gegebenenfalls vorhandenen, wassermischbaren, organischen Lösungsmitteln, ein Gehalt an wasserunlöslichem hydrophoben Polymer in der Deck- und Entklebungsschicht von 30 bis 99,9, vorzugsweise 5 bis 95 Gew.-%, vorliegt.

Die Herstellung der erfindungsgemäßen photostrukturierbaren mehrschichten Elemente kann nach unterschiedlichen aber zum gleichen Schichtaufbau führenden Verfahren erfolgen.

Beispielsweise kann zunächst ein mit einem Haftlack versehener dimensionsstabiler Träger (z.B. hauchverzinntes Stahlblech oder Aluminiumblech) mit einer dünnen Schicht eines Oberlacks (z.B. teilverseiftes Polyvinylacetat, Verseifungsgrad 80 % mit Phenylglycerinethermonocrylat und Glyoxal in wäßrig/alkoholischer Lösung auf der Haftlackschicht aufgetragen, getrocknet und bei ca. 150°C eingebrannt) bedeckt werden und den so vorbehandelten Träger mittels eines Wasser/Alkohol-Gemisches unter Druck (z.B. zwischen zwei Walzen) die photostrukturierbare (= photopolymerisierbare) Schicht aufgeklebt werden, wobei letztere auf einer auf einer Schutzfolie angebrachten Entklebungs- oder Deckschicht angeordnet ist, so daß sich eine Druckplatte des Aufbaus Trägerblech/Haftlack/Oberlack/photostrukturierbare Schicht/Deck- oder Entklebungsschicht/Schutzfolie ergibt.

Hierzu wird auf die mit einer dünnen Phenolharzlackschicht haftvermittelnd eingestellte Schutzfolie (z.B. Polyesterfolie) ein wäßrig/alkoholisches Gemisch, das eine feinteilige Dispersion der wasserunlöslichen hydrophoben Polymeren (z.B. Polystyrol, Polyethylen, Polytetrafluorethylen), wasserlösliches Polymeres (z.B. Polyvinylalkohol) sowie gegebenenfalls Tensid (z.B. auf Basis Polypropylenoxid/Polyethylenoxid) und Entschäumer enthält, in gleichmäßig dünner Schicht (Deckschichttrokkenschichtdicke 0,1 bis 20, vorzugsweise 0,5 bis 10 g/m², z.B. ca. 1,5 g/m²) aufgebracht, getrocknet und darauf die photostrukturierbare Schicht aufgerakelt, so daß sich eine einheitliche Trockenschichtdicke (z.B. ca. 700 μm) ergibt.

Nach einer anderen Methode kann eine ähnlich aufgebaute Druckplatte auch durch aufeinanderfolgende Beschichtung eines Trägers, z.B. eines Aluminiumblechs mit Haftlack, Oberlack, photostrukturierbarer Schicht und Entklebungs- oder Deckschicht hergestellt werden. Wird zusätzlich eine abziehbare Schutzschicht benötigt, kann auf den genannten Schichtverbund auch noch eine Schutzschicht aufgebracht werden, z.B. auch durch Lakkieren mit einem Polyesterlack. Diese Schutzschicht kann dann z.B. vor dem Belichtungsschritt als zusammenhängender Film abgezogen werden.

Die erfindungsgemäße Druckplatte kann in an sich bekannter Weise zu einer Reliefdruckform verarbeitet werden, indem durch Bestrahlung mit aktinischem Licht, superaktinischen Leuchtstofffröhren oder Quecksilber-Mittel-oder Hochdruckbrennern, die gegebenenfalls mit Metallen, wie z.B. Eisen dotiert sein können, bildmäßig belichtet wird, die nicht belichteten Anteile mit Wasser bzw. Wasser/Alkohol-Gemischen ausgewaschen werden und die erhaltene Druckform danach getrocknet und nachbelichtet wird. Die resultierenden Druckformen zeigen eine exakte Bildwiedergabe und ergeben ausgezeichnete Druckergebnisse.

Die in den folgenden Beispielen und Vergleichsbeispielen genannten Teile und Prozente sind, soweit nicht anders angegeben, Gewichtsteile bzw. Gewichtsprozente.

Beispiel 1

1A. Herstellung einer photopolymerisierbaren (= photostrukturierbaren) Masse:
100 Gewichtsteile teilverseiftes Polyvinylacetat mit einem Verseifungsgrad von 80 Mol-% und einem mittleren Molekulargewichtes $\overline{M}_w$ = 20 000 und 50 Gewichtsteile eines gleichartigen teilverseiften Polyvinylacetats, bei dem 4 Mol-% der freien OH-Gruppen mit Methacrylsäureanhydrid in toluolischer Suspension unter N-Methylimidazol-Katalyse verestert sind (gemäß DE-A-35 34 476), wurden in 100 Gewichtsteilen eines Gemisches aus 80 Gewichtsteilen Wasser und 20 Gewichtsteilen n-Propanol innerhalb von 2 Stunden unter Rühren bei 80°C homogen gelöst. In diese Lösung wurden bei 60°C 100 Gewichtsteile Butanglykoldiglycerinetherdiacrylat, 5 Gewichtsteile Benzildimethylketal, 1 Gewicht steil Cyclohexyldiazeniumdioxikalium, 0,1 Gewichtsteile Safranin T (C.I. 50240) und 20 Gewichtsteile N-n-Butyl-benzolsulfonsäureamid eingerührt.

1B. Herstellung eines Stahlträgerbleches für eine photostrukturierbare Druckplatte: Ein 200 μm dickes hauchverzinntes Stahlblech wurde nach einer Oberflächenentfettung mit einem 15 μm dicken Polyurethanhaftlack (gemäß DE-A-30 45 516) beschichtet. Auf diesen Haftlack wurde mit einer Ziehrakelbeschichtungsmaschine ein 2 μm dicker Oberlack aus 90 Gewichtsteilen teilverseiftem Polyvinylacetat des Verseifungsgrades 80 Mol-% und des mittleren Molekulargewichtes $\overline{M}_w$ = 20 000 und 10 Gewichtsteilen Phenylglycerinethermonoacrylat und 0,2 Gewichtsteilen Glyoxal (gemäß DE-A-37 19 844) aus 5%-iger wäßrig/alkoholischer Lösung (Wasser: Ethanol 8:2) so beschichtet und bei 150°C innerhalb 3 Minuten getrocknet/eingebrannt, daß eine Oberlackdicke von 5 μm resultierte.

1C. Herstellung einer erfindungsgemäß präparierten Schutzfolie für eine photostrukturierbare Druckplatte:
Eine 125 μm dicke Polyesterfolie, deren Oberfläche zur Einstellung einer geeigneten Schutzfolienhaftung ggf. durch einen ca. 0,1 bis 0,3 μm dünnen Phenolharzlack haftvermittelnd eingestellt wurde, wurde auf einer mit einem Ziehrakel versehenen Beschichtungsmaschine mit einer wässrigalkoholischen Beschichtungslösung aus 100 Gewichtsteilen Wasser, 10 Gewichtsteilen n-Propanol, 5 Gewichtsteilen feinteiliger Polytetrafluorethylen(= PTFE)dispersion des Feststoffgehaltes 60 Gewicht-% und der mittleren Partikelgröße 0,3 μm, 0,6 Gewichtsteilen teilverseiften Polyvinylacetats (88 Mol-% Verseifungsgrad, mittleres Molekulargewicht $\overline{M}_w$ = 25 000), 0,1 Gewichtsteilen Silikonentschäumer und 0,1 Gewichtsteilen eines nichtionischen schaumarmen Tensids auf Basis Polypropylenoxid/Polyethylenoxid so beschichtet, daß eine Deckschicht-Trockenschichtdicke von 1,5 g/m² resultierte. Eine geeignete Polytetrafluorethylendispersion ist z.B. das Dupont-Verkaufsprodukt Teflon® 30N

1D. Kombination der Stufen 1A, -B und -C zu einer erfindungsgemäßen photostrukturierbaren Druckplatte:
Die Deckfolie 1C. wurde mit der 60°C warmen im Rotationsverdampfer auf 60 Gewichts-% Feststoffgehalt gebrachten, entgasten Beschichtungslösung 1A auf der Ziehrakelmaschine so beschichtet, daß nach 2 stündiger Trocknung bei 80°C eine Trokkenschichtdicke von 700 $\mu$m resultierte. Dabei wurde eine Rakelhöheneinstellung von etwa 2,3 mm benötigt. Anschließend wurde das Trägerblech mittels Wasser/Ethanol 8:2 (nach Gewicht) in einem Spalt zwischen zwei Walzen unter Druck so auf die photopolymerisierbare Schicht aufgeklebt, daß eine Druckplatte des Aufbaus: Trägerblech/Haftlack/Oberlack/photostrukturierbare Schicht/Deckschicht/Schutzfolie entstand. Die so hergestellte Druckplatte wurde zum Ausgleich des Restlösemittelgehaltes und zum Erreichen konstanter Eigenschaften mindestens 24 Stunden gelagert, bevor die Verarbeitung zu einem Druckklischee erfolgte.

1E. Verarbeitung der erfindungsgemäßen photostrukturierbaren Druckplatte zu einem Klischee:
Von der unter 1D beschriebenen Druckplatte wurde die Polyesterschutzfolie abgezogen, wobei die Trennung des Verbundes an der Grenzfläche Deckschicht/Polyesterschutzfolie erfolgte. Auf die freigelegte Oberfläche der Polytetrafluorethylen-haltigen Deckschicht wurde ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt ist, eingelegt. Nach einer Evakuierzeit von nur 10 Sekunden war die Luft zwischen Film und Druckplatte ohne zusätzliche Maßnahmen wie manuelles Anpressen o.ä. einwandfrei entfernt. Die Druckplatte wurde 5 Minuten lang belichtet, wobei die infolge der Photopolymerisation freigesetzte Polymerisationswärme die Druckplattenschicht an der Oberfläche auf 51 bis 53°C Maximaltemperatur erwärmte, wie in einem zusätzlichen Kontrollversuch zur Messung der Maximaltemperatur mittels eines feinen Eisen/Konstantan-Drahtthermoelementes zwischen Film (transparenter Vollflächenbereich) und Druckplattenschicht gemessen wurde. Dieser Temperaturanstieg kann neben der Strahlungswärme im Belichter, dem hohen Gehalt der Druckplatten an flüssigen Monomeren und der niedrigen Glasübergangstemperatur der unbelichteten Druckplattenrohschichten die Ursache für das Verkleben üblicher Druckplatten mit glatten, glänzenden Filmemulsionen sein. Nach der Belichtung zeigte die Druckplatte keinerlei Klebrigkeit gegenüber dem Negativ - beim Kippen der belichteten Druckplatte in die Senkrechte löste sich das Negativ durch sein geringes Eigengewicht von allein von der Oberfläche der Druckplatte ab. Die Emulsionsseite des Filmes zeigte keinerlei Verschmutzungsspuren z.B. durch das verwendete Druckplatten-Monomer. Das Auswaschen der belichteten Druckplatte erfolgte in einem handelsüblichen Reibewascher mit Plüschbezug der Reibeplatte bei 3,5 Minuten Auswaschzeit in reinem Leitungswasser von 25°C und bereitete keinerlei Probleme. Insbesondere wurde keine verlängerte Auswaschzeit gegenüber Platten des Vergleichsversuchs ohne PTFE-Deckschicht beobachtet. Die PTFE-haltige Deckschicht löste sich auch nicht in Form einer zusammenhängenden Haut ab, sondern sie redispergierte zu einer schwach milchigen feinteiligen Dispersion. Die Tendenz zum Absetzen und Verschmutzen des Auswaschers war äußerst gering. Nach dem Auswaschen, Abblasen mit Preßluft und Trocknen des Klischees wurde ein sehr gutes Druckklischee mit sauberen Zwischentiefen und Reliefflanken erhalten. Es zeichnete sich durch ein hervorragendes ruhiges gleichmäßiges Aussehen der Testrasterfelder mit sehr gleichmäßigen Zwischentiefen aus, wie es nur bei sehr gutem Negativkontakt zu erreichen ist. Die Linienbreite von im Negativ 56 $\mu$m breiten Linien wurde im Klischee mittels eines Videomeßmikroskopes ausgemessen und ergab 46 $\mu$m. Eine negative Kopierverbreiterung ist unter Druckern sehr erwünscht, da sie zumindest teilweise den unvermeidbaren Tonwertzuwachs beim Drucken nach dem Hochdruckverfahren (Quetschrandbildung, u.a.) kompensiert.

Vergleichs-Beispiel 1

V1A. Herstellung einer photostrukturierbaren Masse:
Die Herstellung erfolgte exakt wie unter Beispiel 1. beschrieben.

V1B. Herstellung eines Stahlträgerbleches für eine photostrukturierbare Druckplatte:
Die Herstellung erfolgte exakt wie unter Beispiel 1/B. beschrieben.

V1C. Herstellung einer Schutzfolie für eine photostrukturierbare Druckplatte:
Eine 125 $\mu$m dicke Polyesterfolie wurde auf einer mit einem Ziehrakel versehenen Beschichtungsmaschine mit einer wäßrigalkoholischen Beschichtungslösung aus 100 Gewichtsteilen Wasser, 10 Gewichtsteilen n-Propanol, 6 Gewichtsteilen teilverseiften Polyvinylacetats (88 Mol-% Verseifungsgrad, mittleres Molekulargewicht $\overline{M}_w$ = 25 000), so beschichtet, daß eine Deckschicht-Trockenschichtdicke von 1,5 g/m$^2$ resultiert.

V1D. Kombination der Stufen V1A, -B, und -C zu einer photostrukturierbaren Druckplatte:
Die Deckfolie V1C. wurde mit der 60°C warmen im Rotationverdampfer auf 60 Gewichts-% Feststoffgehalt gebrachten, entgasten Beschichtungslösung V1A. auf der Ziehrakelmaschine so beschichtet, daß nach 2 stündiger Trocknung bei 80°C. eine Trockenschichtdicke von 700 μm resultierte. Dabei wurde eine Rakelhöheneinstellung von etwa 2,3 mm benötigt. Anschließend wurde das Trägerblech mittels Wasser/Ethanol 8:2 (nach Gewicht) in einem Spalt zwischen zwei Walzen unter Druck so auf die photopolymerisierbare Schicht aufgeklebt, daß eine Druckplatte des Aufbaus: Trägerblech/Haftlack/Oberlack/photostrukturierbare Schicht/Deckschicht/Schutzfolie entstand. Die so hergestellte Druckplatte wurde zum Ausgleich des Restlösemittelgehaltes und zum Erreichen konstanter Eigenschaften mindestens 24 Stunden gelagert, bevor die Verarbeitung zu einem Druckklischee erfolgte.

V1E. Verarbeitung der photostrukturierbaren Druckplatte zu einem Klischee:

Von der unter V1D. beschriebenen Druckplatte wurde die Polyesterschutzfolie abgezogen, wobei die Trennung des Verbundes an der Grenzfläche Deckschicht/Polyesterschutzfolie erfolgte. Auf die freigelegte Oberfläche der Deckschicht wurde ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt war, eingelegt. Selbst nach einer Evakuierzeit von 10 Minuten war die Luft zwischen Film und Druckplatte nicht zu entfernen. Die Druckplatte wurde 5 Minuten lang belichtet, wobei die infolge der Photopolymerisation freigesetzte Polymerisationswärme die Druckplattenschicht an der Oberfläche auf 51 bis 53°C Maximaltemperatur erwärmte. Nach der Belichtung zeigte die Druckplatte eine starke Klebrigkeit gegenüber dem Negativ - beim manuellen Abziehen des Negativs war ein knatterndes Geräusch zu hören. Die Emulsionsseite des Filmes wies erhebliche Verschmutzungsspuren durch das verwendete Druckplatten-Monomer auf. Nach dem Auswaschen und Trocknen wurde ein fleckiges Druckklischee erhalten. Es hatte ein fleckiges von vielen Unterstrahlungsstellen gezeichnetes Aussehen. Testrasterfelder hatten ungleichmäßige Zwischentiefen und die Kanten von Linien und Vollflächen waren nicht gerade, sondern wiesen insbesondere an den Hohlkopiestellen Verbreiterungen auf. Die Linienbreite von im Negativ 56 μm breiten Linien wurde im Klischee mittels eines Videomeßmikroskopes ausgemessen und ergab 51 μm, allerdings bei großer Streubreite. An Unterstrahlungsstellen waren die Linien bis zu 100 μm breit. Die etwas ungünstigere Kopierverbreiterung wäre noch zu tolerieren; infolge der Ungleichmäßigkeit, hervorgerufen durch die vielen Unterstrahlungen, erfüllte dieses Klischee jedoch nicht die Anforderungen die an ein Druckklischee gestellt werden.

V2 Vergleichsbeispiel mit einer Deckschicht aus teilverseiftem Polyvinylacetat bei Belichtung mit mattem Film

Wurde die Druckplatte des vorigen Vergleichsbeispiels mit mattem Film belichtet, traten infolge der Filmmattierung die geschilderten Unterstrahlungen nicht auf. Nach der Belichtung zeigte die Druckplatte eine ausreichend geringe Klebrigkeit gegenüber dem Negativ - das Negativ fiel zwar von der senkrecht gehaltenen Platte nicht von alleine ab - das manuelle Abziehen des Negativs war jedoch möglich, und obwohl ein leichtes Geräuch bei Abziehen des Negativs zu hören war, zeigte die Emulsionsseite des Filmes nur schwache Verschmutzungsspuren durch das verwendete Druckplatten-Monomer. Nach dem Auswaschen und Trocknen wurde ein gut aussehendes Druckklischee erhalten. Testrasterfelder hatten gleichmäßige Zwischentiefen und gerade Kanten von Linien und Vollflächen. Die Linienbreite von im Negativ 56 μm breiten Linien wurde im Klischee mittels eines Videomeßmikroskopes ausgemessen und ergab 50 μm. Diese Klischees gaben befriedigende Drucke. Da aber die immer häufiger verwendeten glatten Filme nicht verwendet werden können, ist die Einsatzbarkeit einer solchen Druckplatte limitiert.

V3 Vergleichsbeispiel mit einer Deckschicht aus hochverseiftem Polyvinylacetat

Es wurde wie in Beispiel 1 verfahren; die Schutzfolie hatte jedoch eine nicht erfindungsgemäße Deckschicht aus hochverseiftem Polyvinylacetats mit 98 bis 100 Mol-% Verseifungsgrad und einem mittleren Molekulargewicht $\overline{M}_w$ von ca. 25 000. Die Deckschicht-Trockenschichtdicke betrug 2,5 g/m². Von der so hergestellten Druckplatte wurde die Polyesterschutzfolie abgezogen, wobei die Trennung des Verbundes an der Grenzfläche Deckschicht/Polyesterschutzfolie erfolgte. Auf die freigelegte Oberfläche Deckschicht wurde ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt war, eingelegt. Nach einer Evakuierzeit von 2 Minuten war die Luft zwischen Film und Druckplatte weitgehend entfernt. Die Druckplatte wurde 5 Minuten lang belichtet, wobei die infolge der Photopolymerisation freigesetzte Polymerisationswärme die Druckplattenschicht an der Oberfläche auf 51 bis 53° C Maximaltemperatur erwärmte. Nach der Belichtung zeigte die Druckplatte eine geringe Klebrigkeit gegenüber dem Negativ. Das Negativ fiel zwar von der senkrecht gehaltenen Platte nicht von alleine ab - das manuelle Abziehen des Negativs war aber noch leicht möglich und erzeugte kein knatterndes Geräusch. Die Emulsionsseite des Filmes zeigte keine Verschmutzungsspuren durch das verwendete Druckplatten-Monomer. Nach dem Auswaschen und Trocknen wurde ein gut aussehendes Druckklischee erhalten. Testrasterfelder hatten gleichmäßige Zwischentiefen und gerade Linien- und Vollflächenkanten. Die Linienbreite von im Negativ 56 $\mu$m breiten Linien wurde im Klischee mittels eines Videomeßmikroskopes ausgemessen und ergab 62 $\mu$m. Rasterfelder und Linienelemente kopieren relativ breit. Das Druckbild von dieser Druckplatte wirkt schwer und Rasterverläufe z.B. vom 2%igen bis zum 20 %igen Tonwert haben einen harten Tonwert-Abriß, d.h. der hellste noch reproduzierbare Tonwert ist schon so fett (grau), daß ein großer Kontrast zum unbedruckten Papier ins Auge fällt und der reproduzierbare Kontrastumfang zu gering wird. Eine solche Druckplatte ist für Qualitätsdrucke nicht zu gebrauchen.

Beispiel 2

Es wurde wie in Beispiel 1 beschrieben verfahren, anstelle der PTFE-Dispersion in Beispiel 1C wurde jedoch eine Polyethylen-( = PE)-Wachs-Dispersion eingesetzt (z.B. das Handelsprodukt Lanco-Glidd® W) mit einer durchschnittlichen Teilchengröße von 1,8 $\mu$m. Nach der Kombination des Trägers mit dem Verbund aus Schutzfolie, Deckschicht und photostrukturierbaren Schicht in der im Beispiel 1 geschilderten Art und Weise wurde eine photostrukturierbare Druckplatte erhalten. Von der Druckplatte wurde die Polyesterschutzfolie abgezogen, wobei die Trennung des Verbundes an der Grenzfläche Deckschicht/Polyesterschutzfolie erfolgte. Auf die freigelegte Oberfläche der Polyethylen-haltigen Deckschicht wurde ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt war, eingelegt. Nach einer Evakuierzeit von nur 15 Sekunden war die Luft zwischen Film und Druckplatte ohne zusätzliche Maßnahmen wie manuelles Anpressen o.ä. einwandfrei entfernt. Die Druckplatte wurde 5 Minuten lang belichtet. Nach der Belichtung zeigte die Druckplatte fast keine Klebrigkeit gegenüber dem Negativ - das Negativ ließ sich mit minimalem Kraftaufwand ohne hörbares Geräusch von der Druckplatte abnehmen. Die Emulsionsseite des Filmes zeigte keine Verschmutzungsspuren durch das verwendete Druckplatten-Monomer. Das Auswaschen der belichteten Druckplatte erfolgte in einem handelsüblichen Reibewascher mit Plüschbezug der Reibeplatte bei 3,5 Minuten Auswaschzeit in reinem Leitungswasser von 25° c und bereitete keine Probleme. Insbesondere wurde keine verlängerte Auswaschzeit gegenüber Platten des Vergleichsversuch ohne PE-Deckschicht beobachtet. Die polyethylenhaltige Deckschicht löste sich auch nicht in Form einer zusammenhängenden Haut ab, sondern sie redispergierte zu einer schwach milchigen feinteiligen Dispersion. Die Tendenz zum Absetzen und Verschmutzen des Auswaschers war äußerst gering. Nach dem Auswaschen, Abblasen mit Preßluft und Trocknen des Klischees wurde ein sehr gutes Druckklischee mit sauberen Zwischentiefen und Relieflanken erhalten. Es zeichnete sich durch ein ruhiges gleichmäßiges Aussehen der Testrasterfelder mit sehr gleichmäßigen Zwischentiefen aus, wie es nur bei gutem Negativkontakt zu erreichen ist. Die Linienbreite von im Negativ 56 $\mu$m breiten Linien wurde im Klischee mittels eines Videomeßmikroskopes ausgemessen und ergab 47 $\mu$m. Eine negative Kopierverbreiterung ist unter Druckern sehr erwünscht, da sie zumindest teilweise den unvermeidbaren Tonwertzuwachs beim Drucken nach dem Hochdruckverfahren (Quetschrandbildung u.a.) kompensiert.

Beispiel 3

Es wurde wie in Beispiel 1 beschrieben verfahren, anstelle der PTFE-Dispersion gemäß Beispiel 1C wurde jedoch eine feinteilige Polystyrol-Dispersion eingesetzt. Dazu wurde das Handelsprodukt der BASF-AG. Lutofan® 2D durch eine Filterkerze mit 5 $\mu$m Porenweite filtriert, wobei etwa 1/3 des in der Dispersion enthaltenen Festoffs ausfiltriert wurde. Das Filtrat enthielt dann nur noch die Feinanteile mit < 5 $\mu$m Teilchengröße. Die durchschnittliche Teilchengröße lag bei etwa 2 $\mu$m. Nach der Kombination des Trägers mit dem Verbund aus Schutzfolie, Deckschicht und photostrukturierbarer Schicht in der im Beispiel 1 geschilderten Art und Weise wurde eine photostrukturierbare Druckplatte erhalten. Von der Druckplatte wurde die Polyesterschutzfolie abgezogen, wobei die Trennung des Verbundes an der Grenzfläche Deckschicht/Polyesterschutzfolie erfolgte. Auf die freigelegte Oberfläche der polystyrolhaltigen Deckschicht wurde ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Druckplattenbelichters, der mit superaktinischen Leuchtstoffröhren bestückt war, eingelegt. Nach einer Evakuierzeit von 25 Sekunden war die Luft zwischen Film und Druckplatte ohne zusätzliche Maßnahmen wie manuelles Anpressen o.ä. einwandfrei entfernt. Die Druckplatte wurde 5 Minuten lang belichtet. Nach der Belichtung zeigte die Druckplatte nur eine geringe Klebrigkeit gegenüber dem Negativ; das Negativ ließ sich mit minimalem Kraftaufwand von der Druckplatte abnehmen. Die Emulsionsseite des Filmes zeigte keine Verschmutzungsspuren durch das verwendete Druckplatten-Monomer. Das Auswaschen der belichteten Druckplatte erfolgte in einem handelsüblichen Reibewascher mit Plüschbezug der Reibeplatte bei 3,5 Minuten Auswaschzeit in reinem Leitungswasser von 25°C und bereitete keine Probleme. Insbesondere wurde keine verlängerte Auswaschzeit gegenüber Platten des Vergleichsversuchs ohne Polystyrol-Deckschicht beobachtet. Die polystyrolhaltige Deckschicht löste sich auch nicht in Form einer zusammenhängenden Haut ab, sondern sie redispergierte zu einer schwach milchigen feinteiligen Dispersion. Die Tendenz zum Absetzen und Verschmutzen des Auswaschers war sehr gering. Nach dem Auswaschen, Abblasen mit Preßluft und Trocknen des Klischees wurde ein gutes Druckklischee mit sauberen Zwischentiefen und Relieflanken erhalten. Es zeichnete sich durch ein ruhiges gleichmäßiges Aussehen der Testrasterfelder mit gleichmäßigen Zwischentiefen aus, wie es nur bei gutem Negativkontakt zu erreichen ist. Die Linienbreite von im Negativ 56 $\mu$m breiten Linien wurde im Klischee mittels eines Videomeßmikroskopes ausgemessen und ergab 49 $\mu$m. Eine negative Kopierverbreiterung ist unter Druckern sehr erwünscht, da sie zumindest teilweise den unvermeidbaren Tonwertzuwachs beim Drucken nach dem Hochdruckverfahren (Quetschrandbildung u.a.) kompensiert.

Beispiel 4

4A. Herstellung einer photostrukturierbaren Masse:
100 Gewichtsteile eines linearen methanollöslichen Copolyamids aus 33 Mol% Hexamethylendiamin/Adipinsäure-Salz, 33 Mol% $\epsilon$-Caprolaktam und 33 Mol% 4,4'-Diaminodicyclohexylmethan/Adipinsäure-Salz des mittleren Molekulargewichtes $\overline{M}_w$ = 20 000 wurden in 130 Gewichtsteilen eines Mischlösemittels aus 90 Gewichtsteilen Methanol und 10 Gewichtsteilen Wasser innerhalb von 2 Stunden unter Rühren bei 60°C homogen gelöst. In diese Lösung wurden bei 60°C 70 Gewichtsteile des Bisethers aus einem Mol Ethylenglykol und 2 Mol N-Methylolacrylamid, 3 Gewichtsteile Benzildimethylketal, 1 Gewichtsteil Cyclohexyldiazeniumdioxikalium, 0,1 Gewichtsteile Safranin T (C.I. 50240) und 20 Gewichtsteile N-n-Butyl-benzolsulfonsäureamid eingerührt.

4B. Herstellung eines Stahlträgerbleches für eine photostrukturierbare Druckplatte:
Ein 200 $\mu$m dickes hauchverzinntes Stahlblech wurde nach einer Oberflächenentfettung mit einem 15 $\mu$m dicken Polyurethanhaftlack (gemäß DE-A-30 45 516) beschichtet. Auf diesen Haftlack wurde mit der Ziehrakelbeschichtungsmaschine ein nach Trocknung 5 $\mu$m dicker Oberlack aus 80 Gewichtsteilen eines linearen methanollöslichen Copolyamids aus 33 Mol% Hexamethylendiamin/Adipinsäure-Salz, 33 Mol% $\epsilon$-Caprolaktam und 33Mol% 4,4'-Diaminodicyclohexylmethan/Adipinsäure-Salz des mittleren Molekulargewichtes $\overline{M}_w$ = 20000 und 15 Gewichtsteilen eines härtbaren Melamin-Formaldehyd-Kondensates aus etwa 50 gewichts-%iger methanolischer Lösung beschichtet. Dieser Oberlack wurde 5 Minuten lang bei 150°C in einem Umlufttrokenschrank eingebrannt. Das Melamin-Formaldehyd-Kondensat wurde durch Reaktion von Melamin mit überschüssigem Formaldehyd in Gegenwart von Methanol in schwach saurem Medium hergestellt und hatte ein mittleres Molekulargewicht von etwa 400.

4C. Herstellung einer erfindungsgemäßen Schutzfolie für eine photostrukturierbare Druckplatte:
Eine 125$\mu$m dicke Polyesterfolie wurde auf einer mit einem Ziehrakel versehenen Beschichtungsmaschine mit einerBeschichtungslösung aus 100 Gewichtsteilen Wasser, 10 Gewichtsteilen n-Propanol, 5 Gewichtsteilen feinteiliger PTFE-Dispersion des Feststoffgehaltes 60 Gewichts-% und der mittleren Partikelgröße 0,3 $\mu$m, 0,6 Gewichtsteilen teilverseiften Polyethylenoxid-Polyvinylacetat-Copolymers (88 Mol-% Verseifungsgrad, mittleres Molekulargewicht $\overline{M}_w$ = 20 000), 0,1 Gewichtsteilen Silikonentschäumer und 0,1 Gewichtsteilen eines nicht ionischen schaumarmen Tensids auf Basis Polypropylenoxid/Polyethylenoxid so beschichtet, daß eine Deckschicht-Trockenschichtdicke von 1,5 g/m$^2$ resultierte. Eine geeignete PTFE-Dispersion ist z.B. das DuPont-Verkaufsprodukt Teflon 30N.

4D. Kombination der Stufen 4A, -B und -C zu einer photostrukturierbaren Druckplatte:
Die Deckfolie 4C. wurde mit der 60°C warmen im Rotationverdampfer auf 60 Gewichts-% Feststoffgehalt gebrachten, entgasten Beschichtungslösung 4A. auf der Ziehrakelmaschine so beschichtet, daß nach 2 stündiger Trocknung bei 80°C. eine Trockenschichtdicke von 600

μm resultierte. Dabei wurde eine Rakelhöheneinstellung von etwa 2 mm benötigt. Anschließend wurde das Trägerblech mittels Wasser/Ethanol 1:9 (nach Gewicht) in einem Spalt zwischen zwei Walzen unter Druck so auf die photopolymerisierbare Schicht aufgeklebt, daß eine Druckplatte des Aufbaus: Trägerblech/Haftlack/Oberlack/ photostrukturierbare Schicht/Deckschicht/Schutzfolie entstand. Die so hergestellte Druckplatte wurde zum Ausgleich des Restlösemittegehaltes und zum Erreichen konstanter Eigenschaften mindestens 24 Stunden gelagert, bevor die Verarbeitung zu einem Druckklischee erfolgte.

4E. Verarbeitung der photostrukturierbaren Druckplatte zu einem Klischee:

Von der unter 4D. beschriebenen Druckplatte wird die Polyesterschutzfolie abgezogen, wobei die Trennung des Verbundes an der Grenzfläche Deckschicht/Polyesterschutzfolie erfolgt. Auf die freigelegte Oberfläche der Polytetrafluorethylen-haltigen Deckschicht wird ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt ist, eingelegt. Nach einer Evakuierzeit von nur 10 Sekunden war die Luft zwischen Film und Druckplatte ohne zusätzliche Maßnahmen wie manuelles Anpressen o.ä. einwandfrei entfernt. Die Druckplatte wurde 5 Minuten lang belichtet. Nach der Belichtung zeigte die Druckplatte keinerlei Klebrigkeit gegenüber dem Negativ. Beim Kippen der belichteten Druckplatte in die Senkrechte löste sich das Negativ durch sein geringes Eigengewicht von allein von der Oberfläche der Druckplatte ab. Die Emulsionsseite des Filmes zeigte keinerlei Verschmutzungsspuren z.B. durch das verwendete Druckplatten-Monomer. Das Auswaschen der belichteten Druckplatte erfolgte in einem handelsüblichen Sprühwascher bei 6 Minuten Auswaschzeit in Ethanol/Wasser 8:2 von 35°C und bei einem Sprühdruck von 4 Bar und bereitete keinerlei Probleme. Insbesondere wurde keine verlängerte Auswaschzeit gegenüber Platten des Vergleichsversuchs ohne Deckschicht beobachtet. Die PTFE-haltige Deckschicht löste sich auch nicht in Form einer zusammenhängenden Haut ab, sondern sie redispergierte zu einer schwach milchigen feinteiligen Dispersion. Die Tendenz zum Absetzen und Verschmutzen des Auswaschers und der Sprühdüsen war äußerst gering. Nach dem Auswaschen, Abblasen mit Preßluft und Trocknen des Klischees wurde ein sehr gutes Druckklischee mit sauberen Zwischentiefen und Reliefflanken erhalten. Es zeichnete sich durch ein hervorragendes ruhiges gleichmäßiges Aussehen der Testrasterfelder mit sehr gleichmäßigen Zwischentiefen aus, wie es nur bei sehr gutem Negativkontakt zu erreichen ist. Die Linienbreite von im Negativ 56 μm breiten Linien wurde im Klischee mittels eines Videomeßmikroskopes ausgemessen und ergab 45 μm. Diese negative Kopierverbreiterung ist unter Druckern sehr erwünscht, da sie zumindest teilweise den unvermeidbaren Tonwertzuwachs beim Drucken nach dem Hochdruckverfahren (Quetschrandbildung u.a.) kompensiert.

Vergleichs-Beispiel 4

V4A. Herstellung einer photostrukturierbaren Masse:

Die Herstellung erfolgte exakt wie unter Beispiel 4 beschrieben.

V4B. Herstellung eines Stahlträgerbleches für eine photostrukturierbare Druckplatte:

Die Herstellung erfolgte exakt wie unter Beispiel 4B. beschrieben.

V4C. Herstellung einer Schutzfolie für eine photostrukturierbare Druckplatte:

Eine 125 μm dicke Polyesterfolie wird auf einer mit einem Ziehrakel versehenen Beschichtungsmaschine mit einer wäßrigalkoholischen Beschichtungslösung aus 100 Gewichtsteilen Wasser, 10 Gewichtsteilen n-Propanol, 6 Gewichtsteilen teilverseiften Polyvinylacetats (88 Mol-% Verseifungsgrad, mittleres Molekulargewicht $\overline{M}_w$ = 25 000) so beschichtet, daß eine Deckschicht-Trockenschichtdicke von 1,5 $g/m^2$ resultiert.

V4D. Kombination der Stufen V4A. -B. und -C. zu einer photostrukturierbaren Druckplatte:

Die Deckfolie V4C. wird mit der 60°C warmen im Rotationverdampfer auf 60 Gewichts-% Feststoffgehalt gebrachten, entgasten Beschichtungslösung V4A. auf der Ziehrakelmaschine so beschichtet, daß nach 2 stündiger Trocknung bei 80°C. eine Trockenschichtdicke von 700 μm resultiert. Dabei wird eine Rakelhöheneinstellung von etwa 2,3 mm benötigt. Anschließend wird das Trägerblech mittels Wasser/Ethanol 8:2 (nach Gewicht) in einem Spalt zwischen zwei Walzen unter Druck so auf die photostrukturierbare Schicht aufgeklebt, daß eine Druckplatte des Aufbaus: Trägerblech/Haftlack/Oberlack/ photostrukturierbare Schicht/Deckschicht/Schutzfolie entsteht. Die so hergestellte Druckplatte wird zum Ausgleich des Restlösemittegehaltes und zum Erreichen konstanter Eigenschaften mindestens 24 Stunden gelagert, bevor die Verarbeitung zu einem Druckklischee erfolgt.

V4E.Verarbeitung der photostrukturierbaren Druckplatte zu einem Klischee:

Von der unter V4D. beschriebenen Druckplatte wird die Polyesterschutzfolie abgezogen, wobei die Trennung des Verbundes an der Grenzfläche Deckschicht/Polyesterschutzfolie erfolgt. Auf die freigelegte Oberfläche der Deckschicht wird ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt ist, eingelegt. Selbst nach einer Evakuierzeit von 10 Minuten war die Luft zwischen Film und Druckplatte nicht zu entfernen. Die Druckplatte wurde 5 Minuten lang belichtet, wobei die infolge der Photopolymerisation freigesetzte Polymerisationswärme die Druckplattenschicht an der Oberfläche auf 51 bis 53°C Maximaltemperatur erwärmte. Nach der Belichtung zeigte die Druckplatte eine starke Klebrigkeit gegenüber dem Negativ. Beim manuellen Abziehen des Negativs war ein knatterndes Geräusch zu hören. Die Emulsionsseite des Filmes wies erhebliche Verschmutzungsspuren durch das verwendete Druckplatten-Monomer auf. Nach dem Auswaschen und Trocknen wurde ein fleckiges Druckklischee erhalten. Es hatte ein fleckiges von vielen Unterstrahlungsstellen gezeichnetes Aussehen. Testrasterfelder hatten ungleichmäßige Zwischentiefen; Linien- und Vollflächenkanten waren nicht gerade, sondern wiesen insbesondere an den Hohlkopiestellen Verbreiterungen auf. Die Linienbreite von im Negativ 56 $\mu$m breiten Linien wurde im Klischee mittels eines Videomeßmikroskopes ausgemessen und ergab 51 $\mu$m, allerdings bei großer Streübreite. An Unterstrahlungsstellen waren die Linien bis zu 100 $\mu$m breit. Die etwas ungünstigere Kopierverbreiterung wäre noch zu tolerieren; infolge der Ungleichmäßigkeit, hervorgerufen durch die vielen Unterstrahlungen, erfüllt dieses Klischee jedoch nicht die Anforderungen, die an ein Druckklischee gestellt werden.

V5. Vergleichsbeispiel mit einer Deckschicht aus teilverseiftem Polyvinylacetat bei Belichtung mit mattem Filmnegativ

Wird die Druckplatte des vorigen Vergleichsbeispieles V4. mit mattem Filmnegativ belichtet, treten infolge der Filmmattierung die geschilderten Unterstrahlungen nicht auf. Nach der Belichtung zeigte die Druckplatte eine ausreichend geringe Klebrigkeit gegenüber dem Negativ. Das Negativ fiel zwar von der senkrecht gehaltenen Platte nicht von alleine ab; das manuelle Abziehen des Negativs war jedoch möglich, und obwohl ein leichtes Geräusch bei Abziehen des Negativs zu hören war, zeigte die Emulsionsseite des Filmes nur schwache Verschmutzungsspuren durch das verwendete Druckplatten-Monomer. Nach dem Auswaschen und Trocknen wurde ein gut aussehendes Druckklischee erhalten. Testrasterfelder hatten gleichmäßige Zwischentiefen und gerade Kanten von Linien- und Vollflächen. Die Linienbreite von im Negativ 56 $\mu$m breiten Linien wurde im Klischee mittels eines Videomeßmikroskopes ausgemessen und ergab einen noch zufriedenstellenden Wert von 50 $\mu$m. Da aber die immer häufiger verwendeten glatten Filme nicht verwendet werden können, ist die Einsatzbarkeit einer solchen Druckplatte limitiert.

Beispiel 5

5A. Herstellung einer photostrukturierbaren Masse:

100 Gewichtsteile eines anionisch polymerisierten toluollöslichen Dreiblockcopolymeren aus Styrol-Isopren-Styrol, z.B. Kraton® 1107 der Shell Chemical Co., Houston, Texas, USA, wurden zusammen mit 12 Gewichtsteilen Hexandioldiacrylat, 2 Gewichtsteilen Benzildimethylketal und 0,8 Gewichtsteilen Kerobit® TBK 60% ig innerhalb von 2 Stunden unter Rühren bei 70°C in Toluol gelöst.

5B. Herstellung eines Stahlträgerbleches für eine photostrukturierbare Druckplatte:

Ein 200 $\mu$m dickes hauchverzinntes Stahlblech wird nach einer Oberflächenentfettung mit einem 15 $\mu$m dicken Polyurethanhaftlack (gemäß DE-A-30 45 516) beschichtet. Dieser einschichtige Haftlack darf bei der späteren Verklebung mit der photopolymerisierbaren Schicht höchstens 48 Stunden alt sein, um ausreichende Haftungen zu gewährleisten.

5C. Herstellung einer erfindungsgemäßen Schutzfolie für eine photostrukturierbare Druckplatte:

Eine 125$\mu$m dicke Polyesterfolie wird auf einer mit einem Ziehrakel versehenen Beschichtungsmaschine mit einer Beschichtungslösung aus 100 Gewichtsteilen Wasser, 10 Gewichtsteilen n-Propanol, 5 Gewichtsteilen feinteiliger PTFE-Dispersion des Feststoffgehaltes 60 Gewichts-% und der mittleren Partikelgröße 0,3 $\mu$m, 0,3 Gewichtsteilen teilverseiften Polyethylenoxid-Polyvinylacetat-Copolymer (88 Mol-% Verseifungsgrad, mittleres Molekulargewicht $\overline{M}_w$ = 20 000), 0,1 Gewichtsteilen Silikonentschäumer und 0,1 Gewichtsteilen eines nicht ionischen schaumarmen Tensids auf Basis Polypropylenoxid/Polyethylenoxid so beschichtet, daß eine Deckschicht-Trockenschichtdicke von 1,5 g/m$^2$ resultiert.

5D. Kombination der Stufen 5A. -B. und -C. zu einer photostrukturierbaren gummielastischen Druckplatte:

Die Schutzfolie 5C. wird mit der 60°C warmen im Rotationverdampfer auf 60 Gewichts-% Feststoffgehalt gebrachten, entgasten Beschichtungslösung 5A. auf der Ziehrakelmaschine so beschichtet, daß nach 2 stündiger Trocknung bei 80°C eine Trockenschichtdicke von 600 $\mu$m resultiert. Dabei wird eine Rakelhöheneinstellung von etwa 2 mm benötigt. Anschließend wird das auf ca. 130°C aufgeheizte Trägerblech unter Druck so auf die photostrukturierbare Schicht aufgeklebt, daß eine Druckplatte des Aufbaus: Trägerblech/Haftlack/photostrukturierbare Schicht/Deckschicht/Schutzfolie entsteht. Die so hergestellte Flexo-Druckplatte auf Stahlträgerblech wird zum Ausgleich des Restlösemittelgehaltes und zum Erreichen konstanter Eigenschaften mindestens 5 Tage gelagert, bevor die Verarbeitung zu einem Druckklischee erfolgt.

5E. Verarbeitung der photostrukturierbaren Druckplatte zu einem Klischee:

Von der unter 5D. beschriebenen Druckplatte wird die Polyesterschutzfolie abgezogen, wobei die Trennung des Verbundes an der Grenzfläche Deckschicht/Polyesterschutzfolie erfolgt. Auf die freigelegte Oberfläche der Polytetrafluorethylen-haltigen Deckschicht wird ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt ist, eingelegt. Nach einer Evakuierzeit von nur 10 Sekunden war die Luft zwischen Film und Druckplatte ohne zusätzliche Maßnahmen, wie manuelles Anpressen o.ä. einwandfrei entfernt. Die Druckplatte wurde 15 Minuten lang belichtet. Nach der Belichtung zeigte die Druckplatte keinerlei Klebrigkeit gegenüber dem Negativ - beim Kippen der belichteten Druckplatte in die Senkrechte löste sich das Negativ durch sein geringes Eigengewicht von allein von der Oberfläche der Druckplatte ab. Die Emulsionsseite des Filmes zeigte keinerlei Verschmutzungsspuren z.B. durch das verwendete Druckplatten-Monomer. Das Auswaschen der belichteten Druckplatte erfolgte in einem handelsüblichen Durchlaufwascher mit reinem Perchlorethylen als Auswaschmittel, innerhalb von 10 Minuten ohne Alkoholzusatz bei einer Temperatur von 25°C und bereitete keinerlei Probleme. Insbesondere wurde keine verlängerte Auswaschzeit beobachtet. Die PTFE-haltige Deckschicht löste sich auch nicht in Form einer zusammenhängenden Haut ab, sondern sie redispergierte zu einer schwach milchigen feinteiligen Dispersion. Die Tendenz zum Absetzen und Verschmutzen des Auswaschers war äußerst gering. Nach dem Auswaschen, Abblasen mit Preßluft und Trocknen des Klischees wurde ein gutes Druckklischee mit sauberen Zwischentiefen und Reliefflanken erhalten. Es zeichnete sich durch ein ruhiges gleichmäßiges Aussehen der Testrasterfelder und gleichmäßige Zwischentiefen aus, wie es nur bei sehr gutem Negativkontakt zu erreichen ist. Die Linienbreite von im Negativ 56 $\mu$m breiten Linien wurde im Klischee mittels eines Videomeßmikroskopes ausgemessen und ergab 49 $\mu$m. Diese negative Kopierverbreiterung ist unter Druckern sehr erwünscht, da sie zumindest teilweise den unvermeidbaren Tonwertzuwachs beim Drucken nach dem Hochdruck- oder Flexodruckverfahren (Quetschrandbildung u.a.) kompensiert.

Vergleichs-Beispiel 6

V6A. Herstellung einer photostrukturierbaren Masse:

Die Herstellung erfolgte exakt wie unter Beispiel 5 beschrieben.

V6B.Herstellung eines Stahlträgerbleches für eine photostrukturierbare Druckplatte:

Die Herstellung erfolgte exakt wie unter Beispiel 5B beschrieben.

V6C. Herstellung einer Schutzfolie für eine photostrukturierbare Druckplatte:

Eine 125 $\mu$m dicke Polyesterfolie wird auf einer mit einem Ziehrakel versehenen Beschichtungsmaschine mit einer wässrigalkoholischen Beschichtungslösung aus 100 Gewichtsteilen Wasser, 10 Gewichtsteilen n-Propanol, 4 Gewichtsteilen teilverseiften Polyvinylacetat (88 Mol-% Verseifungsgrad, mittleres Molekulargewicht $\overline{M}_w$ = 25 000), so beschichtet, daß eine Deckschicht-Trockenschichtdicke von 1,5 g/m$^2$ resultiert.

V6D.Kombination der Stufen V5A. -B. und -C. zu einer photostrukturierbaren Druckplatte:

Die Schutzfolie V6C. wird mit der 60°C warmen im Rotationsverdampfer auf 60 Gewichts-% Feststoffgehalt gebrachten, entgasten Beschichtungslösung V5A auf der Ziehrakelmaschine so beschichtet, daß nach 2 stündiger Trocknung bei 80°C eine Trockenschichtdicke von 600 $\mu$m resultiert. Dabei wird eine Rakelhöheneinstellung von etwa 2 mm benötigt. Anschließend wird das auf ca. 130°C aufgeheizte Trägerblech unter Druck so auf die photopolymerisierbare Schicht aufgeklebt, daß eine Druckplatte des Aufbaus: Trägerblech/Haftlack/photostrukturierbare-

Schicht/Deckschicht/Schutzfolie entsteht. Die so hergestellte Flexo-Druckplatte auf Stahlträgerblech wird zum Ausgleich des Restlösemittegehaltes und zum Erreichen konstanter Eigenschaften mindestens 5 Tage gelagert, bevor die Verarbeitung zu einem Druckklischee erfolgt.

V6E. Verarbeitung der photostrukturierbaren Druckplatte zu einem Klischee:

Von der unter V6D. beschriebenen Druckplatte wird die Polyesterschutzfolie abgezogen, wobei die Trennung des Verbundes an der Grenzfläche Deckschicht/Polyesterschutzfolie erfolgt. Auf die freigelegte Oberfläche der Polytetrafluorethylen-haltigen Deckschicht wird ein 20 x 30 cm großes Filmnegativ mit einer glatten hochglänzenden Halogensilberemulsion, wie es üblicherweise nur zur Belichtung von Offsetdruckformen benutzt wird, aufgelegt und das Ganze in einen Vakuumkopierrahmen eines Photopolymerdruckplattenbelichters, der mit superaktinischen Leuchtstoffröhren bestückt ist, eingelegt. Nach einer Evakuierzeit von nur 10 Sekunden war die Luft zwischen Film und Druckplatte ohne zusätzliche Maßnahmen, wie manuelles Anpressen o.ä. einwandfrei entfernt. Die Druckplatte wurde 15 Minuten lang belichtet. Nach der Belichtung zeigte die Druckplatte keinerlei Klebrigkeit gegenüber dem Negativ - beim Kippen der belichteten Druckplatte in die Senkrechte löste sich das Negativ durch sein geringes Eigengewicht von allein von der Oberfläche der Druckplatte ab. Die Emulsionsseite des Filmes zeigte keinerlei Verschmutzungsspuren z.B. durch das verwendete Druckplatten-Monomer. Es wurde versucht, die belichtete Druckplatte in einem handelsüblichen Durchlaufwascher mit reinem Perchlorethylen als Auswaschmittel ohne Alkoholzusatz bei einer Temperatur von 25°C. auszuwaschen. Nach 15 Minuten Auswaschzeit war die Platte noch nicht ausgewaschen. Bei längeren Zeiten konnte kein gleichmäßiges Auswaschen erreicht werden. In den Zwischentiefen blieben immer Reste der Deckschicht aus Polyvinylalkohol zurück, die z.T. die Zwischentiefen in Rasterflächen überspannten. Abhilfe brachte hier nur ein vorgeschalteter Auswaschschritt mit Wasser als Auswaschmittel. Die Linienbreite von im Negativ 56 $\mu$m breiten Linien wurde im Klischee einer solchen praxisfremd erst in Wasser und dann in Perchlorethylen ausgewaschenen Platte mittels eines Videomeßmikroskopes ausgemessen und ergab 48 $\mu$m. Diese negative Kopierverbreiterung ist erwünscht, da sie zumindest teilweise den unvermeidbaren Tonwertzuwachs beim Drucken nach dem Hochdruck- oder Flexodruckverfahren (Quetschrandbildung u.a.) kompensiert. Eine Druckplatte gemäß diesem Vergleichsversuch vereint zwar drei Vorzüge, die auch den erfindungsgemäßen Deckschichten eigen ist: Durch Verzicht auf Alkohol im Auswaschlösungsmittel werden, im Fall von Perchlorethylen nicht brennbares Auswaschmittel, im Fall höhersiedender Erdölfraktionen als Auswaschmittel Flammpunkte oberhalb 60°C erreicht und weiterhin erzielt man eine sehr gute Entklebung der Rohplatte mit dem Effekt eines hervorragenden Vakuumkontaktes sowie eine ausreichende Sauerstoffpermeabilität. Ein zweistufiges Auswaschen, wie es in diesem Vergleichsversuch geschildert wird, ist aber viel zu kompliziert und praxisfremd, so daß eine solche Druckplatte keinen wirtschaftlichen Erfolg haben kann.

Vergleichsversuch V7

Es wurden Platten exakt wie Vergleichversuch V6. hergestellt mit der einen Ausnahme, daß die Deckschicht nicht aus Polyvinylalkohol, sondern aus einer üblichen nicht erfindungsgemäßen Deckschicht aus einem linearen alkohollöslichen Polyamid: Makromelt® 6900 der Fa. Henkel (wie sie z.B. in der EP-A-0 504 824 beschrieben ist) besteht. Solche Druckplatten mit einer sehr dünnen Polyamiddeckschicht lassen sich in reinem Perchlorethylen auch bei verlängerter Auswaschzeit nicht korrekt auswaschen. Sie erfordern zur einstufigen Auswaschbarkeit einen Alkoholzusatz im Auswaschmittel, der selbst bei Perchlorethylen als Lösungsmittel die Klassifizierung des Auswaschmittel als "leicht entflammbar Flammpunkt < 60°C" erfordert und damit den Einsatz teurer EX-geschützter Wascher und Räume verlangt. Außerdem erfodern Zweikomponenten-Auswaschmittel eine ständige Kontrolle des richtigen Mischungsverhälnisses, das sich z.B. leicht durch Abdampfen von Perchlorethylen verändert.

**Patentansprüche**

1. Photostrukturierbares mehrschichtiges Element zur Herstellung von Reliefformen, bestehend aus mindestens einer festen photostrukturierbaren Schicht und einer darauf angebrachten Entklebungs- oder Deckschicht, wobei die photostrukturierbare Schicht, gegebenenfalls mittels einer Haftschicht, auf einem dimensionsstabilen Träger aufgebracht ist, dadurch gekennzeichnet, daß die auf der photostrukturierbaren Schicht angebrachte Entklebungs- oder Deckschicht aus einer transparenten mikrodispersen mehrphasigen Schicht eines oder mehrer feinteiliger hydrophober wasserunlöslicher Polymerer mit einem Primärpartikeldurchmesser von 0,01 bis 10 $\mu$m, die von mindestens einem ionischen oder nichtionischen Tensid oder einem polymeren Bindemittel, das wasserlöslich oder wasserquellbar ist, oder von einem Gemisch aus derartigem Tensid und derartigem polymeren Bindemittel umhüllt sind, besteht, wobei der Anteil der feinteiligen hydrophoben wasserunlöslichen Polymeren in der Entklebungs- oder Deckschicht 30 bis 99,9 Gew.-% der Gesamtmenge der Entklebungs- oder Deckschicht beträgt.

2. Element nach Anspruch 1, dadurch gekennzeichnet, daß die Entklebungs- oder Deckschicht als feinteiliges hydrophobes wasserunlösliches Polymer ein Polyolefin oder Polytetrafluorethylen enthält.

3. Element nach einem der Ansprüche 1 oder 2, dadurch gekennzeichnet, daß die Entklebungs- oder Deckschicht als wasserlösliches oder wasserquellbares polymeres Bindemittel Polyvinylalkohol, ein Polyvinylalkoholderivat oder Polyamid enthält.

4. Element nach einem der vorhergehenden Ansprüche, dadurch gekennzeichnet, daß zusätzlich in Wasser nicht lösliche Bindemittel in der Entklebungs- oder Deckschicht vorhanden sind.

5. Verfahren zur Herstellung eines mehrschichtigen photostrukturierbaren Elements nach einem der vorhergehenden Ansprüche, dadurch gekennzeichnet, daß die Entklebungs- oder Deckschicht durch Auftragen einer wasserhaltigen Dispersion eines feinteiligen hydrophoben wasserunlöslichen Polymeren, die ein ionisches oder nichtionisches Tensid und/oder ein wasserlösliches oder wasserquellbares polymeres Bindemittel enthält, auf die photostrukturierbare Schicht hergestellt wird.

6. Verfahren nach Anspruch 5, dadurch gekennzeichnet, daß als wasserhaltige Dispersion eines feinteiligen hydrophoben wasserunlöslichen Polymeren eine wasserhaltige Dispersion eines Polyolefins oder Polytetrafluorethylens eingesetzt wird.

7. Reliefformen zum Drucken oder Prägen, dadurch gekennzeichnet, daß sie aus einem Mehrschichtelement des Schichtaufbaus Träger/Haftlack/Oberlack/photostrukturierte Schicht/Deck- oder Entklebungsschicht/Schutzfolie nach Abziehen der Schutzfolie durch bildmäßiges Belichten und Entwickeln erhalten worden ist, wobei im Mehrschichtelement die Kombination photostrukturierbare Schicht/Deck- oder Entklebungsschicht gemäß den Ansprüchen 1 bis 4 eingesetzt wurde.

Europäisches
Patentamt

**EUROPÄISCHER RECHERCHENBERICHT**

Nummer der Anmeldung

EP 94 10 3958

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | DE-A-21 27 767 (E.I. DU PONT DE NEMOURS) <br> * das ganze Dokument * <br> --- | 1-7 | G03F7/11 |
| X | EP-A-0 175 244 (HOECHST) <br> * das ganze Dokument * <br> --- | 1-7 | |
| A | EP-A-0 530 962 (MINNESOTA MINING AND MANUFACTURING) <br> --- | | |
| D,A | EP-A-0 092 782 (E.I. DU PONT DE NEMOURS) <br> & US-A-4599299 <br> ----- | | |

| RECHERCHIERTE SACHGEBIETE (Int.Cl.5) |
|---|
| G03F |

Der vorliegende Recherchenbericht wurde für alle Patentansprüche erstellt

| Recherchenort | Abschlußdatum der Recherche | Prüfer |
|---|---|---|
| DEN HAAG | 2. Juni 1994 | Haenisch, U |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

......................................................................

& : Mitglied der gleichen Patentfamilie, übereinstimmendes Dokument

EPO FORM 1503 03.82 (P04C03)